# EUROPÄISCHE PATENTSCHRIFT

(11) **EP 4 264 305 B1**
(45) Veröffentlichungstag und Bekanntmachung des Hinweises auf die Patenterteilung: **30.10.2024**
(21) Anmeldenummer: 21805909.5
(22) Anmeldetag: 02.11.2021
(51) Int. Cl.: G01R 33/38

(54) **VERFAHREN ZUM LAGEFIXIERTEN VERBINDEN EINES SCHLAUCHFÖRMIGEN ELEMENTS AUF EINER TRÄGERPLATTE**
METHOD FOR A POSITIONALLY FIXED CONNECTION OF A TUBULAR ELEMENT ON A SUPPORT PLATE
PROCÉDÉ DE RACCORDEMENT À POSITION FIXE D'UN ÉLÉMENT TUBULAIRE SUR UNE PLAQUE DE SUPPORT

(30) Priorität: 17.12.2020 DE 102020133923
(43) Veröffentlichungstag der Anmeldung: 25.10.2023
(73) Patentinhaber: Isovolta Gatex GmbH, 92442 Wackersdorf (DE)
(72) Erfinder: BENDER, Heinz, 74889 Sinsheim-Eschelbach (DE); WOPPMANN, Reinhold, 92442 Wackersdorf (DE)
(74) Vertreter: Glück Kritzenberger Patentanwälte PartGmbB
(86) Internationale Anmeldenummer: PCT/EP2021/080393
(87) Internationale Veröffentlichungsnummer: WO 2022/128232

(56) Entgegenhaltungen:
- DE-A1- 102004 053 879
- JP-A- 2015 012 191
- JP-A- S6 285 411
- US-A1- 2008 024 134
- US-B2- 9 645 210

## Beschreibung

Die vorliegende Erfindung betrifft ein Verfahren zum lagefixierten Verbinden eines schlauchförmigen Elementes auf einer Trägerplatte. Ferner betrifft die vorliegende Erfindung ein System zum lagefixierten Verbinden eines schlauchförmigen Elementes auf einer Trägerplatte.

Dabei sind dem Fachmann aus dem Stand der Technik unterschiedlichste Verfahren zum lagefixierten Verbinden eines schlauchförmigen Elementes auf einer Trägerplatte bekannt.

Insbesondere können solcherart hergestellte Baugruppen bzw. Vorbaugruppen, bestehend aus einer Trägerplatte mit einem daran angeordneten schlauchförmigen Element, in Magnetresonanz -Tomographen zur Kühlung der Spulenwicklungen verbaut bzw. eingesetzt werden. Man kennt diese Baugruppen bzw. Vorbaugruppen auch unter der Bezeichnung Kühlplatten.

Die Magnetresonanztomographie ist ein bildgebendes Verfahren, das vor allem in der medizinischen Diagnostik zur Darstellung von Struktur und Funktion der Gewebe und Organe im Körper eingesetzt wird. Es basiert physikalisch auf den Prinzipien der Kernspinresonanz, insbesondere der Feldgradienten-NMR, und wird daher auch als Kernspintomographie bezeichnet. Die ebenfalls zu findende Abkürzung MRI stammt von der englischen Bezeichnung Magnetic Resonance Imaging.

Mit der MRT können Schnittbilder des menschlichen (oder tierischen) Körpers erzeugt werden, die eine Beurteilung der Organe und vieler krankhafter Organveränderungen erlauben. Sie basiert auf - in einem Magnetresonanztomographiesystem erzeugten - sehr starken Magnetfeldern sowie magnetischen Wechselfeldern im Radiofrequenzbereich, mit denen bestimmte Atomkerne im Körper resonant angeregt werden, wodurch in einem Empfängerstromkreis ein elektrisches Signal induziert wird.

Da somit das zu beobachtende Objekt "selbst strahlt", unterliegt die MRT nicht dem physikalischen Gesetz zum Auflösungsvermögen optischer Instrumente, nach dem die Wellenlänge der verwendeten Strahlung umso kleiner sein muss, je höher die geforderte Auflösung ist.

In der MRT können mit Wellenlängen im Meterbereich Objektpunkte im Submillimeterbereich aufgelöst werden. Eine wesentliche Grundlage für den Bildkontrast sind die Protonendichte und unterschiedliche Relaxationszeiten verschiedener Gewebearten. Daneben trägt auch der unterschiedliche Gehalt an Wasserstoff-Atomen in verschiedenen Geweben (z. B. Muskel, Knochen) zum Bildkontrast bei.

Im Gerät wird keine belastende Röntgenstrahlung oder andere ionisierende Strahlung erzeugt oder genutzt. Allerdings sind die Wirkungen der magnetischen Wechselfelder auf lebendes Gewebe nicht vollständig erforscht.

Mehr im Detail können in der Magnetresonanztomographie zur Ortskodierung Magnetfeldgradienten eingesetzt werden, die durch Gradientenspulen erzeugt werden. Die

Magnetfeldgradienten werden innerhalb von Millisekunden an- und abgeschalten, weshalb durch Induktion Wirbelströme auf den die Gradientenspulen umgebenden leitfähigen Strukturen gebildet werden. Die Wirbelströme erzeugen wiederum magnetisch Wirbelfelder, welche die resultierenden Bilder in der Magnetresonanztomographie störend beeinflussen und deren Qualität mindern. Entscheidend für die Entstehung der Wirbelfelder sind Strukturen des Magnetresonanzgerätes, die eine hohe elektrische Leitfähigkeit aufweisen.

Wie bereits erwähnt, werden derartige Kühlplatten in MRT-Geräten zum Kühlen der Spulenwicklungen verbaut. Hierzu werden diese als Baugruppe herstellten Kühlplatten mit den Spulenwicklungen des MRT-Gerätes vergossen. Damit sind die Kühlplatten mehr oder weniger untrennbar mit den Spulenwicklungen des MRT-Gerätes verbunden.

Der Verbindungsprozess der als Kühlschläuche fungierenden schlauchförmigen Elemente mit der als GFK-Isolierplatte ausgebildeten Trägerplatte war bisher zeitaufwändig und damit teuer. Zudem konnten die im wesentlichen mäanderförmig auf die Trägerplatten gelegten Kühlschläuche nicht alle einzeln und beabstandet zueinander mit der Trägerplatte verbunden werden, sondern teils paarweise und kontaktschlüssig aneinander liegend. Dies kann zu einer Verringerung der Kühlleistung der Kühlplatte führen. Insbesondere werden die Kühlschläuche an der Trägerplatte hierfür sämtlich händisch verknotet.

Aus der Druckschrift US 2008/024 134 A1 ist ein Verfahren zur Herstellung einer Kühleinrichtung für eine Gradientenspule bekannt geworden, wobei die Kühleinrichtung wenigstens einen flexiblen, an einer Trägerplatte gemäß eines vorgegebenen Musters verlaufend angeordneten Kühlschlauch umfasst. Diese Druckschrift zeichnet sich insbesondere dadurch aus, dass der wenigstens eine einen runden Querschnitt aufweisende, gemäß dem vorgegebenen Muster gelegte Kühlschlauch zur bleibenden Verformung seiner Querschnittsform flach gedrückt wird.

Ferner ist aus der Druckschrift US 9 645 210 B2 eine Wärmemanagementkomponente bekannt geworden die, sofern vorhanden, mindestens eine Komponente eines Magnetresonanztomographiesystems kühlen kann, wobei die Wärmemanagementkomponente dazu geeignet ist, die Wirbelstromerzeugung während des Betriebs des MRT-Systems zu reduzieren oder zu eliminieren. Dazu umfasst die Wärmemanagementkomponente mindestens eine Leitung, die zum Zirkulieren von Kühlmittel konfiguriert ist und mindestens ein wärmeleitendes Substrat, das mit der mindestens einen Leitung gekoppelt und dazu konfiguriert ist, Wärme von der mindestens einen Komponente auf das Kühlmittel zu übertragen, wenn es durch die mindestens eine Leitung zirkuliert, wobei das mindestens eine wärmeleitende Substrat dazu eingerichtet ist, Wirbelströme zu reduzieren oder zu eliminieren.

Schließlich ist aus der DE 10 2004 053 879 A1 eine Kühleinrichtung für eine elektrische Komponente bekannt geworden, die ein nichtmagnetisches thermisch leitendes Verteilersubstrat und wenigstens eine schlangenförmige Kühlröhre aufweist, die auf dem thermisch leitenden Verteilersubstrat in thermischem Kontakt mit diesem so angeordnet ist, dass bei in Betrieb befindlicher wenigstens einer schlangenförmiger Kühlröhre das Substrat gekühlt ist.

Aufgabe der vorliegenden Erfindung ist es dabei, ein Verfahren und ein System zum lagefixierten Verbinden eines schlauchförmigen Elementes auf einer Trägerplatte aufzuzeigen, das die Nachteile der aus dem Stand der Technik bekannten Verfahren überwindet und zudem ein kostengünstiges und zuverlässiges Verbinden der schlauchförmigen Elemente mit der Trägerplatte sicherstellt.

Zur Lösung dieser Aufgabe ist ein Verfahren zum lagefixierten Verbinden eines schlauchförmigen Elementes auf einer Trägerplatte entsprechend dem Patentanspruch 1 ausgebildet.

Ferner wird zur Lösung der Aufgabe ein System zum lagefixierten Verbinden eines schlauchförmigen Elementes auf einer Trägerplatte mit den Merkmalen des Anspruchs 18 angegeben. Die jeweiligen Unteransprüche betreffen dabei besonders vorteilhafte Ausführungsvarianten der Erfindung.

Der wesentliche Aspekt der vorliegenden Erfindung ist darin zu sehen, ein Verfahren zum lagefixierten Verbinden zumindest eines schlauchförmigen Elementes auf einer Trägerplatte mittels zumindest eines fadenförmigen Verbindungselementes über vordefinierte Öffnungen der Trägerplatte anzugeben, bei dem das zumindest eine schlauchförmige Element in vordefinierten Schlauchhaltebahnen einer als Montagehilfe ausgebildeten Wickelplatte angeordnet wird. Ferner wird bei dem Verfahren erfindungsgemäß auf die in den Schlauchhaltebahnen befindlichen schlauchförmigen Elemente der Wickelplatte eine Trägerplatte mit vordefinierten Öffnungen aufgelegt und durch die Wickelplatte in einer indexierten Position relativ zu der Wickelplatte gehalten, wobei in der indexierten Position unterhalb der vordefinierten Öffnungen der Trägerplatte in der Wickelplatte korrespondierende Ausnehmungen vorgesehen sind. Es wird also die Trägerplatte auf die Wickelplatte aufgelegt, in der sich bereits die schlauchförmigen Elemente in die Schlauchhaltebahnen eingelegt befinden und damit die Trägerplatte durch die Wickelplatte in einer indexierten, also eindeutigen Position gehalten. Schließlich werden bei dem Verfahren ferner erfindungsgemäß die schlauchförmigen Elemente maschinell mittels des zumindest einen fadenförmigen Verbindungselementes über die vordefinierten Öffnungen mit der Trägerplatte verbunden. Mittels dem erfindungsgemäßen Verfahren können die schlauchförmigen Elemente vorteilhaft über ihren gesamten Verlauf beabstandet zueinander und möglichst jedes schlauchförmige Element einzeln mit der Trägerplatte kostengünstig und zuverlässig verbunden werden. Gemäß einer vorteilhaften Ausführungsvariante kann dabei vorgesehen sein, dass die Wickelplatte mittels einer Verschiebeeinrichtung motorisch gesteuert und/oder geregelt in zumindest zwei um vorzugsweise 90° zueinander verlaufenden Verschieberichtungen auf einem Bearbeitungstisch verschoben wird.

Gemäß einer weiteren vorteilhaften Ausführungsvariante kann dabei vorgesehen sein, dass die Verschiebeeinrichtung einen Verschiebeschlitten aufweist, der über zumindest eine Koppeleinrichtung mit der Wickelplatte lösbar verbunden wird.

Gemäß einer nochmals weiteren vorteilhaften Ausführungsvariante kann dabei vorgesehen sein, dass der Verschiebeschlitten getaktet oder kontinuierlich in den beiden Verschieberichtungen jeweils beidseitig motorisch gesteuert und/oder geregelt angetrieben verschoben wird.

Gemäß einer nochmals weiteren vorteilhaften Ausführungsvariante kann dabei vorgesehen sein, dass der Verschiebschlitten ein Bewegungsprofil vollzieht, bei dem der Verschiebeschlitten periodisch auf eine Verschiebegeschwindigkeit beschleunigt und anschließend wieder abgebremst wird.

Gemäß einer nochmals weiteren vorteilhaften Ausführungsvariante kann dabei vorgesehen sein, dass das zumindest eine schlauchförmige Element in an einer Plattenoberseite der Wickelplatte als nutförmige Vertiefung ausgebildete Schlauchhaltebahnen eingebracht wird, die mäanderförmig zumindest über einen Teilbereich der Plattenoberseite verlaufen.

Gemäß einer nochmals weiteren vorteilhaften Ausführungsvariante kann dabei vorgesehen sein, dass das schlauchförmige Element zumindest mit einem Teilabschnitt seines Außendurchmessers form- und/oder kontaktschlüssig in der jeweiligen Schlauchhaltebahn gehalten wird.

Gemäß einer nochmals weiteren vorteilhaften Ausführungsvariante kann dabei vorgesehen sein, dass die Trägerplatte über einen gegenüber der Plattenoberseite hochspringenden Randabschnitt verschiebesicher auf der Wickelplatte in der indexierten Position gehalten wird.

Gemäß einer nochmals weiteren vorteilhaften Ausführungsvariante kann dabei vorgesehen sein, dass eine eindeutige Soll-Lage der Trägerplatte relativ auf der Wickelplatte über zumindest eine Indexierungseinrichtung festgelegt wird.

Gemäß einer nochmals weiteren vorteilhaften Ausführungsvariante kann dabei vorgesehen sein, dass über die Längserstreckung der jeweiligen Ausnehmung eine Verbindungsbahn mit einem Verbindungsanfang und einem Verbindungsende ausgebildet wird, entlang der die jeweiligen schlauchförmigen Elemente maschinell mittels des zumindest einen fadenförmigen Verbindungselementes über die vordefinierten Öffnungen mit der Trägerplatte verbunden werden.

Gemäß einer nochmals weiteren vorteilhaften Ausführungsvariante kann dabei vorgesehen sein, dass als schlauchförmiges Element ein elastisch verformbarer Kühlmittelschlauch verwendet wird.

Gemäß einer nochmals weiteren vorteilhaften Ausführungsvariante kann dabei vorgesehen sein, dass die schlauchförmigen Elemente mittels einer als Nähmaschine, insbesondere als Doppelsteppstichmaschine, ausgebildeten Verbindungsvorrichtung mit der Trägerplatte verbunden werden, die eine oszillierend auf und ab bewegbare Nadelstange mit einer daran angeordneten Nadel aufweist, wobei die Nadel zur Aufnahme eines als Oberfaden ausgebildeten ersten fadenförmigen Verbindungselementes von einer Oberfadenspule vorgesehen wird, wobei die Verbindungsvorrichtung zudem eine Greifervorrichtung aufweist, deren rotative Bewegung mit der oszillierenden Bewegung der Nadelstange synchronisiert wird, wobei ein als Unterfaden ausgebildetes zweites fadenförmiges Verbindungselementes auf einer Unterfadenspule aufgenommen wird und wobei die Greifervorrichtung mit der Unterfadenspule in Nadelstichrichtung unterhalb der Nadel angeordnet wird.

Gemäß einer nochmals weiteren vorteilhaften Ausführungsvariante kann dabei vorgesehen sein, dass mittels wenigstens einer in zumindest einer Ausnehmung vorgesehenen Rückhaltevorrichtung eine Rückhaltekraft auf das durch die Nadel in die Rückhaltevorrichtung eingestochene erste Verbindungselement ausgeübt wird, die größer ist, als die Abzugskraft für das erste fadenförmige Verbindungselement von der Oberfadenspule.

Gemäß einer nochmals weiteren vorteilhaften Ausführungsvariante kann dabei vorgesehen sein, dass als fadenförmiges Verbindungselement ein geflochtener Endloszwirn verwendet wird, der insbesondere aus 100% Polyester hergestellt ist und/oder eine Festigkeit von in etwa 21.000 bis ca. 55.000 cN und/oder eine Bruchdehnung von in etwa 11% bis ca. 28% und/oder einen Thermoschrumpf bei 160° C über 30 min von kleiner als 7,5% aufweist.

Gemäß einer nochmals weiteren vorteilhaften Ausführungsvariante kann dabei vorgesehen sein, dass das jeweilige schlauchförmige Element mit der Trägerplatte mittels der Verbindungsvorrichtung entlang der jeweiligen Verbindungsbahn der korrespondierenden Ausnehmung über die entsprechend vordefinierte Öffnung der Trägerplatte zumindest einmal, vorteilhaft mehrfach, verbunden wird.

Gemäß einer nochmals weiteren vorteilhaften Ausführungsvariante kann dabei vorgesehen sein, dass die Wickelplatte mittels des Verschiebeschlittens zwischen benachbarten vordefinierten Öffnungen der auf der Wickelplatte angeordneten Trägerplatte entlang der korrespondierenden Ausnehmung getaktet bewegt wird und zwar vorzugsweise derart, dass die Nadel der Verbindungseinrichtung mit ihrer jeweiligen Längserstreckung lotrecht oberhalb der vordefinierten, aktuell zu verbindenden Öffnung der Trägerplatte in der jeweiligen Stillstandsphase eines Taktschrittes angeordnet wird, wobei während der Stillstandsphase das jeweilige in einer Schlauchhaltebahn der Wickelplatte aufgenommene schlauchförmige Element maschinell mittels des zumindest einen fadenförmigen Verbindungselementes über diese vordefinierte Öffnung mit der Trägerplatte verbunden wird.

Gemäß einer nochmals weiteren vorteilhaften Ausführungsvariante kann dabei vorgesehen sein, dass Wickelplatte mittels des Verschiebeschlittens zwischen benachbarten vordefinierten Öffnungen der auf der Wickelplatte angeordneten Trägerplatte kontinuierlich entlang der korrespondierenden Ausnehmung bewegt wird und zwar vorzugsweise derart, dass die Nadel der Verbindungseinrichtung mit ihrer Längserstreckung jeweils zumindest während des Zeitraums des maschinellen Verbindens des jeweiligen in der Schlauchhaltebahn der Wickelplatte aufgenommenen schlauchförmigen Elements mittels des zumindest einen fadenförmigen Verbindungselementes oberhalb oder im Wesentlichen oberhalb der jeweiligen vordefinierten Öffnung der Trägerplatte steht, über die das schlauchförmige Element mit der Trägerplatte verbunden wird.

Gemäß einem weiteren Aspekt betrifft die vorliegende Erfindung ein System zum lagefixierten Verbinden zumindest eines schlauchförmigen Elementes auf einer Trägerplatte mittels zumindest eines fadenförmigen Verbindungselementes über vordefinierte Öffnungen der Trägerplatte, zumindest aufweisend einen Bearbeitungstisch mit einer daran angeordneten Verschiebeeinrichtung sowie einer Verbindungseinrichtung zum maschinellen Verbinden der schlauchförmigen Elemente mittels des zumindest einen fadenförmigen Verbindungselementes über die vordefinierten Öffnungen mit der Trägerplatte, wobei das System zur Durchführung des erfindungsgemäßen Verfahrens ausgebildet ist.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

Obwohl manche Aspekte im Zusammenhang mit einer Vorrichtung beschrieben wurden, versteht es sich, dass diese Aspekte auch eine Beschreibung des entsprechenden Verfahrens darstellen, so dass ein Block- oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparates) wie z. B. einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Die Erfindung wird im Folgenden anhand der Figuren an Ausführungsbeispielen näher erläutert. Es zeigen:
- Fig. 1: in vereinfachter schematischer Draufsicht eine beispielhafte Ausführungsvariante eines erfindungsgemäßen Systems zum lagefixierten Verbinden zumindest eines schlauchförmigen Elementes auf einer Trägerplatte mittels zumindest eines fadenförmigen Verbindungselementes über vordefinierte Öffnungen der Trägerplatte, das zur Durchführung des erfindungsgemäßen Verfahrens ausgebildet ist;

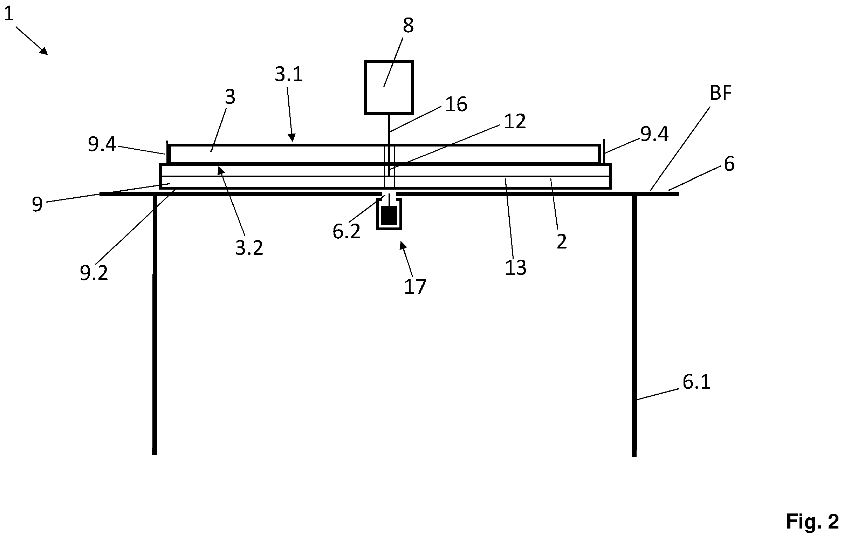

- Fig. 2: in grob schematischer und vereinfachter Seitenansicht das System gemäß Figur 1;

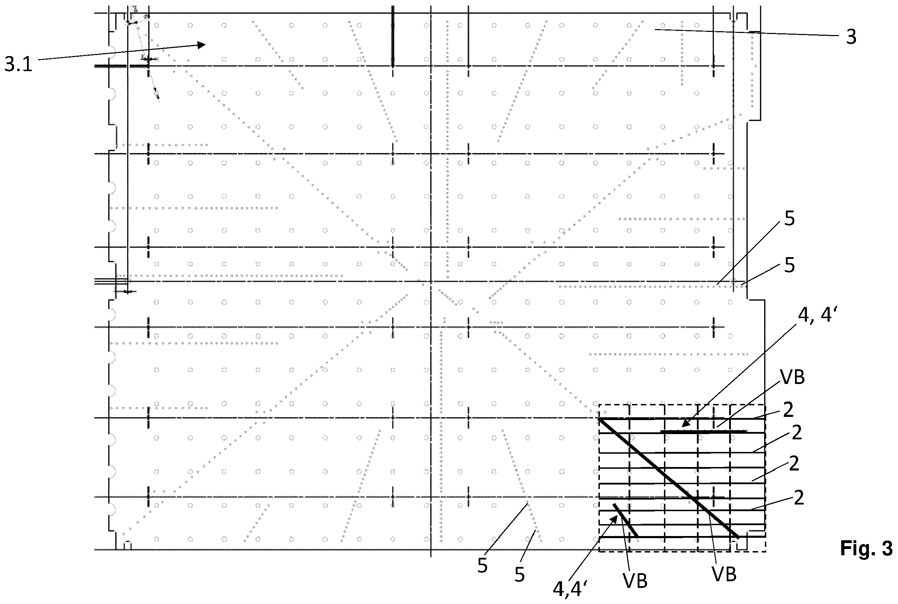

- Fig. 3: in vereinfachter Darstellung eine Draufsicht auf eine freigestellte Trägerplatte mit in einem Teilbereich daran angeordneten schlauchförmigen Elementen;
- Fig. 4: eine vereinfachte Perspektivansicht eines nur teilweise dargestellten Systems mit einer beispielhaften Ausführungsvariante einer Verbindungseinrichtung.

Für gleiche oder gleich wirkende Elemente der Erfindung werden in den Figuren identische Bezugszeichen verwendet. Ferner werden der Übersichtlichkeit halber nur Bezugszeichen in den einzelnen Figuren dargestellt, die für die Beschreibung der jeweiligen Figur erforderlich sind. Auch ist die Erfindung in den Figuren nur als schematische Ansicht zur Erläuterung der Arbeitsweise dargestellt. Insbesondere dienen die Darstellungen in den Figuren nur der Erläuterung des grundlegenden Prinzips der Erfindung. Aus Gründen der Übersichtlichkeit ist darauf verzichtet worden, alle Bestandteile der Vorrichtung zu zeigen.

Das in den Figuren allgemein mit 1 bezeichnete System ist dabei zur Durchführung des erfindungsgemäßen Verfahrens zum lagefixierten Verbinden zumindest eines schlauchförmigen Elementes 2 auf einer Trägerplatte 3 mittels zumindest eines fadenförmigen Verbindungselementes 4, 4' über vordefinierte Öffnungen 5 der Trägerplatte 3 ausgebildet.

Hierfür weist das System zum lagefixierten Verbinden des zumindest einen schlauchförmigen Elementes 2 auf der Trägerplatte 3 mittels des zumindest einen fadenförmigen Verbindungselementes 4, 4' über vordefinierte Öffnungen 5 der Trägerplatte 3 einen Bearbeitungstisch 6 mit einem Tischgestell 6.1 auf, auf dem die schlauchförmigen Elemente 2 mittels dem fadenförmigen Verbindungselement 4, 4' mit der Trägerplatte 3 verbunden werden können. Der Bearbeitungstisch 6 dient dabei insbesondere zum Auflegen und/oder motorisch gesteuerten Verschieben einer Wickelplatte 9 mit daran angeordneten schlauchförmigen Elementen 2.

Der Bearbeitungstisch 6 hat beispielsweise eine in Draufsicht viereckförmige Grundform und ist beispielsweise rechteckig, insbesondere quadratisch ausgebildet. Ferner bildet der Bearbeitungstisch 6 eine Oberseite OS und eine der Oberseite OS gegenüberliegende Unterseite US aus. Dabei spannt die Oberseite OS in einer Bearbeitungsebene E eine Bearbeitungsfläche BF auf, im Wesentlichen plan ausgebildet ist. Das Tischgestell 6.1 ist an der Unterseite US des Bearbeitungstisches 6 angeordnet und steht auf einer Bodenebene BE auf.

An der Oberseite OS des Bearbeitungstisches 6 des Systems 1 ist zudem eine Verschiebeeinrichtung 7, sowie ein Verbindungeinrichtung 8 zum maschinellen Verbinden der schlauchförmigen Elemente 2 mittels des zumindest einen fadenförmigen Verbindungselementes 4, 4' mit der Trägerplatte 3 vorgesehen, insbesondere angeordnet. Die Verbindungseinrichtung 8 wird nachstehend noch nähergehend erläutert, ist dabei jedoch orstfest an der Oberseite OS des Bearbeitungstisches 6 vorgesehen, insbesondere angeordnet und kann dabei beispielsweise mit der Oberseite OS verschraubt sein.

Die Verschiebeeinrichtung 7 kann dabei zum motorisch gesteuerten und/oder geregelten Verschieben einer als Montagehilfe ausgebildeten Wickelplatte 9 in zumindest zwei um vorzugsweise 90° zueinander verlaufenden Verschieberichtungen X, Y ausgebildet sein.

Mehr im Detail kann dabei die Verschiebeeinrichtung 7 zum motorisch gesteuerten und/oder geregelten Verschieben der Wickelplatte 9 jeweils beidseitig in beiden Verschieberichtung X und Y ausgebildet sein. In anderen Worten kann also die Wickelplatte 9 in und entgegen der Verschiebrichtung X sowie in und entgegen der Verschieberichtung Y motorisch gesteuert und/oder geregelt mittels der Verschiebeeinrichtung 7 auf der Bearbeitungsfläche BF des Bearbeitungstisches 6 verschoben werden.

Insbesondere weist die Verschiebeeinrichtung 7 hierfür einen Verschiebeschlitten 10 auf, der über zumindest eine Koppeleinrichtung 11 mit der Wickelplatte 9 lösbar verbindbar ist. Mehr im Detail kann dabei über die zumindest eine Koppeleinrichtung 11 die Wickelplatte 9 in einer indexierten Position mit der Verschiebeeinrichtung 7 unter Zwischenschaltung des Verschiebeschlittens 10 angeordnet werden. Dabei kann der Verschiebeschlitten 10 der Verschiebeeinrichtung 7 über eine nicht nähergehend dargestellte und gezeigte Steuereinrichtung angesteuert werden, und dabei vorzugsweise getaktet oder kontinuierlich in den beiden Verschieberichtungen X und Y beidseitig motorisch gesteuert und/oder geregelt angetrieben verschoben werden.

Unter "getaktet" wird im Rahmen der vorliegenden Erfindung eine intermittierende Bewegung verstanden, die sich im Gegensatz zu einer kontinuierlichen Bewegung durch schrittweise oder periodisch wiederkehrende Bewegungsabläufe auszeichnet, und zwar mit einem Stillstand nach oder vor jedem Bewegungsschritt.

Ein intermittierend bewegtes Element kann beispielsweise ein, um einen gewissen Schiebeweg bewegter Verschiebeschlitten 10 kann, der hierbei ein Bewegungsprofil vollzieht, bei dem der Verschiebeschlitten 10 periodisch nahezu stoß- und/oder ruckfrei auf eine gewisse Verschiebegeschwindigkeit beschleunigt und anschließend wieder abgebremst wird.

Auch die Wickelplatte 9 kann dabei beispielsweise eine in Draufsicht viereckförmige, beispielsweise rechteckige, insbesondere quadratische geometrische Grundform aufweisen. Insbesondere ist die Wickelplatte 9 dabei plattenförmig, vorzugsweise flach und plan, ausgebildet und weist dabei eine Plattenoberseite 9.1 und eine der Plattenoberseite 9.1 gegenüberliegende Plattenunterseite 9.2 auf. Insbesondere sind die Plattenoberseite 9.1 und die Plattenunterseite 9.2 jeweils plan ausgebildet. Dabei ist die Plattenoberseite 9.1 parallel zur Plattenunterseite 9.2 vorgesehen. Die Wickelplatte 9 liegt dabei zumindest teilflächig, vorzugsweise vollflächig kontaktschlüssig mit ihrer Plattenunterseite 9.2 auf der durch die Oberseite OS des Bearbeitungstisches 6 aufgespannten Bearbeitungsfläche BF auf. Vorzugsweise ist die Plattenunterseite 9.2 der Wickelplatte 9 gegenüber der Bearbeitungsfläche BF relativ verschiebbar mittels des Verschiebeschlittens 10 der Verschiebeinrichtung 7 ausgebildet.

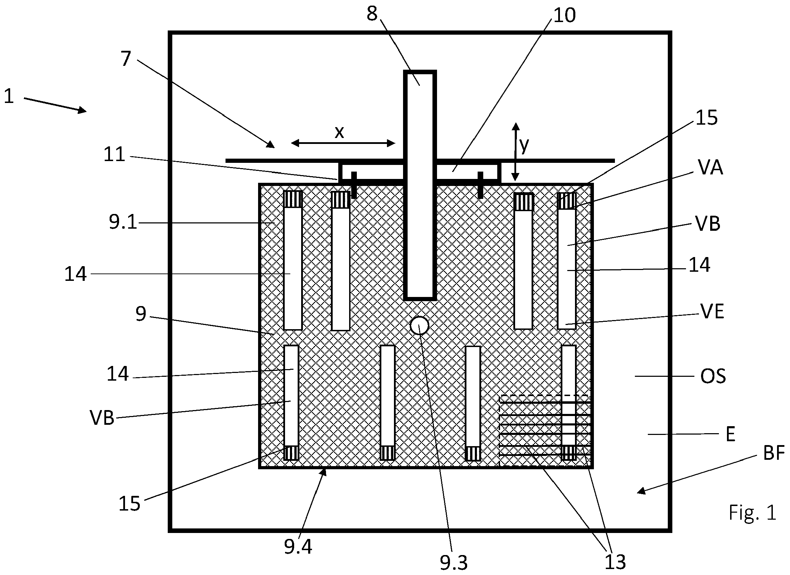

Dabei kann die Wickelplatte 9 aus einem Kunststoff herstellt sein. Ferner weist die als Montagehilfe ausgebildete Wickelplatte 9 vordefinierte Schlauchhaltebahnen 13 zum Halten des zumindest einen schlauchförmigen Elements 2 auf. Die Schlauchhaltebahnen 13 sind dabei als nutförmige Vertiefung gegenüber der Plattenoberseite 9.1 der Wickelplatte 9 ausgebildet. Insbesondere sind dabei mehrere Schlauchhaltebahnen 13 an der Plattenoberseite 9.1 der Wickelplatte 9 vorgesehen, die mäanderförmig zumindest über eine Teilfläche, vorzugsweise die Gesamtfläche, der Plattenoberseite 9.1 verlaufen. Dabei sind die Schlauchhaltebahnen 13 in der Figur 1 nur beispielhaft in einem Teilbereich der Plattenoberseite 9.1 gezeigt, der durch ein strichliert umrandetes Rechteck kenntlich gemacht ist.

Die nutförmigen Schlauchhaltebahnen 13 sind dabei vorzugsweise zum lagefixierten Halten des zumindest einen schlauchförmigen Elementes 2 ausgebildet. Beispielsweise kann das zumindest eine schlauchförmige Element 2 wenigstens mit einem Teilabschnitt seines Außenumfangs form- und/oder kontaktschlüssig in der jeweiligen nutförmigen Schlauchhaltebahn 13 aufgenommen gehalten werden. Dabei ist die geometrische Form der Vertiefung der Schlauchhaltebahn 13 insbesondere an den Außendurchmesser des zumindest einen schlauchförmigen Elementes 2 angepasst.

Ferner kann die Wickelplatte 9 an ihrer Plattenoberseite 9.1 einen gegenüber der Plattenoberseite 9.1 hochspringenden Randabschnitt 9.4 aufweisen. Der Randabschnitt 9.4 ist also als Erhöhung gegenüber der Plattenoberseite 9.1 ausgebildet und vorzugsweise zumindest teilumfänglich, vorteilhaft vollumfänglich, freiendseitig an der Plattenoberseite 9.1 der Wickelplatte 9 vorgesehen. Insbesondere kann dabei die Trägerplatte 3 durch den Randabschnitt 9.4 in einer indexierten, verschiebsicheren Position auf der Plattenoberseite 9.1 der Wickelplatte 9 angeordnet werden. Vorteilhaft kommen hierfür in der indexierten Position der Trägerplatte 3 auf der Wickelplatte 9 die freien Seitenränder der Trägerplatte 2 in Berührungskontakt mit dem Randabschnitt 9.4 der Wickelplatte 9. In anderen Worten liegen also die stirnseitigen Außenumfangsflächen der Trägerplatte 3 an der Innenumfangsseite des Randabschnittes der Wickelplatte 9 an.

Ferner kann die Wickelplatte 9 für die Erlangung einer eindeutig indexierten Position, also einer eindeutigen relativen Lageposition der Trägerplatte 3 auf der Wickelplatte 9, eine Indexierungseinrichtung 9.3 aufweisen, über die eine gewünschte eindeutige Soll-Lage der Trägerplatte 3 relativ auf der Wickelplatte 9 festlegbar ist. Beispielsweise kann die Indexierungseinrichtung 9.3 als auf der Plattenoberseite 9.1 der Wickelplatte 9 vorgesehener Indexstift ausgebildet sein, der in einer in der Trägerplatte 3 korrespondiere Indexöffnung 3.1 eingreift, wenn die Trägerplatte 3 in der vordefinierten Soll-Lage auf die Wickelplatte 9 aufgelegt ist.

Überdies weist die Wickelplatte 9 mehrere Ausnehmungen 14 in Form von Durchbrechungen auf, die also von der Plattenoberseite 9.1 bis zur Plattenunterseite 9.2 reichen und die Wickelplatte 9 in ihrer vollständigen Dicke durchdringen, also durchbrechen. Die Ausnehmungen 14 sind dabei also als Durchgangsöffnungen durch die Dicke der Wickelplatte 9 vorgesehen. Vorzugsweise sind die Ausnehmungen 14 im Wesentlichen quaderförmig mit jeweils abgerundeten Stirnseiten, wobei die Stirnseitenflächen an Querseitenflächen ausgebildet sind. In Draufsicht auf die Wickelplatte 9 weisen die Ausnehmungen 14 damit eine im Wesentlichen reckeckige Grundform, jedoch mit abgerundeten Querseitenflächen, auf.

Über die Längserstreckung der jeweiligen Ausnehmung 14 der Wickelplatte 9 kann dabei eine Verbindungsbahn VB ausgebildet werden, entlang der die jeweiligen in einer entsprechenden Schlauchhaltebahn 13 aufgenommenen schlauchförmigen Elemente 2 maschinell mittels des zumindest einen fadenförmigen Verbindungselementes 4, 4' über die vordefinierten Öffnungen 5 mit der Trägerplatte 3 verbunden werden können. Insbesondere verlaufen die Verbindungsbahnen VB in einem Winkel kleiner oder gleich 90°, jedoch insbesondere nicht parallel, zu den Schlauchhaltebahnen 13.

Die Verbindungsbahn VB bildet dabei jeweils an ihrem einen Ende einen Verbindungsanfang VA und an ihrem, dem Verbindungsanfang VA gegenüberliegenden Ende ein Verbindungsende VE aus. Insbesondere ist die jeweilige Verbindungsbahn VB kongruent zu der entsprechend korrespondierenden Ausnehmung 14 ausgebildet.

Insbesondere kann in der jeweiligen Ausnehmung 14 eine Rückhaltevorrichtung 15, beispielsweise in Form eines Montageschaums oder zweier gegenüberliegender, gegenseitig verspannter Klemmbacken, vorgesehen sein. Dabei ist die Rückhaltevorrichtung 15 insbesondere zumindest im Bereich des Verbindungsanfangs VA der jeweiligen über die Längserstreckung der Ausnehmung 14 ausgebildeten Verbindungsbahn VB vorgesehen. Beispielsweise kann die Rückhaltevorrichtung 15 in Form eines Montageschaums in die Ausnehmung 14 eingespritzt, oder eingeklebt werden. Alternativ kann die Rückhaltevorrichtung 15 auch aus Polystyrol hergestellt werden.

Ferner kann auch die Trägerplatte 3 dabei beispielsweise eine in Draufsicht viereckförmige, beispielsweise rechteckige, insbesondere quadratische geometrische Grundform aufweisen. Insbesondere ist auch die Trägerplatte 3 plattenförmig, vorzugsweise flach und plan, ausgebildet und weist dabei eine Trägerplattenoberseite 3.1 und eine der Trägerplattenoberseite 3.1 gegenüberliegende Trägerplattenunterseite 3.2 auf. Insbesondere sind die Trägerplattenoberseite 3.1 und die Trägerplattenunterseite 3.2 jeweils plan ausgebildet. Dabei verläuft die Trägerplattenoberseite 3.1 parallel zur Trägerplattenunterseite 3.2. Die Trägerplatte 3 liegt dabei zumindest teilflächig, vorzugsweise vollflächig kontaktschlüssig mit ihrer Trägerplattenunterseite 3.2 auf der Wickelplatte 9, insbesondere der Plattenoberseite 9.1 der Wickelplatte 9, auf. Insbesondere ist die Trägerplatte 3 verschiebegesichert auf der Wickelplatte 9 angeordnet, und zwar in einer indexierten Lage.

Dabei kann die Trägerplatte 3 aus einem elektrisch isolierendem Material, insbesondere einem Verbundwerkstoff, besonders vorteilhaft einem glasfaserverstärkten Verbundwerkstoff, hergestellt sein.

Ferner weist die Trägerplatte 3 mehrere, die Trägerplatte 3 vollständig durchdringenden Öffnungen 5 auf. Insbesondere befinden sich die Öffnungen 5 der Trägerplatte 3 in der indexierten Position oberhalb der Ausnehmungen 14 der Wickelplatte 9 angeordnet. Insbesondere weisen die Öffnungen 5 einen Innendurchmesser auf, der mindestens 10%, vorteilhaft zwischen 20% und 40% größer ausgebildet ist aus eine Außendurchmesser der Nadel 12 der Verbindungseinrichtung 8. Die Nadel 12 kommt damit nicht in Berührungskontakt mit der jeweiligen Öffnung 5 während des Verbindens des schlauchförmigen Elementes 2 mit der Trägerplatte 3. In anderen Worten sind also in der Position der Trägerplatte 3 auf der Wickelplatte 9 unterhalb der vordefinierten Öffnungen 5 der Trägerplatte 3 die korrespondierenden Ausnehmungen 14 der Wickelplatte 9 vorgesehen.

Bei dem schlauchförmigen Element 2 kann es sich insbesondere um einen fluidführenden, bzw. fluidführbaren Schlauch, insbesondere einen Kühlmittelschlauch, handeln, das mit einem Kühlmittel beaufschlagbar ist. Insbesondere ist das schlauchförmige Element 2 aus einem Kunststoff hergestellt und elastisch verformbar ausgebildet. Insbesondere können dabei mehrere schlauchförmige Elemente 2 in den Schlauchhaltebahnen 13 der Wickelplatte 9 aufgenommen sein.

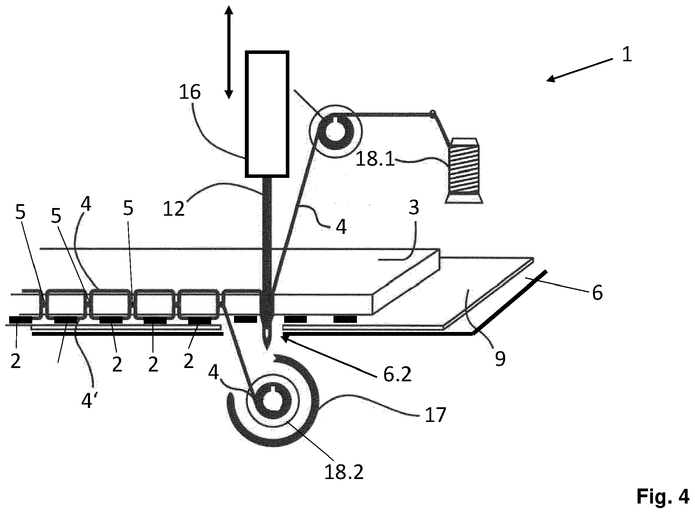

Die Verbindungsvorrichtung 8 ist dabei zum maschinellen Verbinden der schlauchförmigen Elemente 2 mittels des zumindest einen fadenförmigen Verbindungselementes 4, 4' mit der Trägerplatte 3 ausgebildet. Die Verbindungsvorrichtung 8 kann dabei als Nähmaschine ausgebildet sein, mittels der eine Verbindung der schlauchförmigen Elemente 2 an der Trägerplatte 3 als Doppelsteppstich erzeugbar ist. Dabei ist in der Figur 4 die Verbindungsvorrichtung 8 nur grob schematisch dargestellt. Dabei weist die als Doppelsteppstichmaschine ausgebildete Verbindungsvorrichtung 8 eine oszillierend auf und ab (Doppelpfeil in Figur 4) bewegbare Nadelstange 16 mit einer daran angeordneten Nadel 12 auf. Die Nadel 12 ist insbesondere zur Aufnahme eines als Oberfaden ausgebildeten ersten fadenförmigen Verbindungselementes 4 von einer Oberfadenspule 18.1 ausgebildet. Unterhalb einer Öffnung 6.1 des Bearbeitungstisches 6 ist dabei eine Greifervorrichtung 17 angeordnet, deren rotative Bewegung mit der oszillierenden Bewegung der Nadelstange 16 synchronisiert ist. Ein als Unterfaden ausgebildetes zweites fadenförmiges Verbindungselementes 4' befindet sich auf einer Unterfadenspule 18.2, die in einem nicht nähergehend dargestellten Spulenkapselträger der Greifervorrichtung 17 angeordnet ist. Die Greifervorrichtung 17 mit Unterfadenspule 18.2 befindet sich dabei in Nadelstichrichtung unterhalb der Nadel 12 angeordnet. Die Greifervorrichtung 17 führt hierbei in an sich bekannter Weise das von der Nadel 12 geführte, als Oberfaden ausgebildete erste fadenförmige Verbindungselement 4 um den Spulenkapselträger, damit dieser zusammen mit dem als Unterfaden ausgebildeten zweiten fadenförmigen Verbindungselement 4' eine Naht ausbildet. Dabei können die Nadelstange 16 und die Greifervorrichtung 17 von einem gemeinsamen Antrieb, nämlich einem nicht nähergehend gezeigten Servo-Elektromotor angetrieben werden, dessen rotative Antriebsbewegung zur Nadelstange 16 und zur Greifervorrichtung 17 von einer Maschinenhauptwelle abgegriffen und in einem bestimmten Verhältnis übersetzt wird.

Die in der jeweiligen Ausnehmung 14 vorgesehene Rückhaltevorrichtung 15 ist dabei dazu ausgebildet, am Verbindungsanfang VA der entsprechenden Verbindungsbahn VB eine Rückhaltekraft auf das durch die Nadel 12 in die Rückhaltevorrichtung 15 eingestochene erste Verbindungselement 4 auszuüben, die größer ist, als die Abzugskraft für das erste fadenförmige Verbindungselement 4 von der Oberfadenspule 18.1.

Das zumindest eine fadenförmige Verbindungselement 4, 4' kann dabei ein geflochtener Endloszwirn sein, der insbesondere aus 100% Polyester hergestellt ist. Insbesondere kann das fadenförmige Verbindungselement 4, 4' eine Festigkeit von in etwa 21.000 bis ca. 55.000 cN aufweisen und/oder eine Bruchdehnung von in etwa 11% bis ca. 28% und/oder einen Thermoschrumpf bei 160° C über 30 min von kleiner als 7,5%.

Mehr im Detail werden hierfür zunächst die schlauchförmigen Element 2 in den vordefinierten Schlauchhaltebahnen 13 der als Montagehilfe ausgebildeten Wickelplatte 9 angeordnet, insbesondere eingelegt. Anschließend wird auf die in den Schlauchhaltebahnen 13 befindlichen schlauchförmigen Elemente 2 der Wickelplatte 9 die Trägerplatte 3 mit den vordefinierten Öffnungen 5 aufgelegt und durch die Wickelplatte in einer indexierten Position relativ zu der Trägerplatte 3 gehalten, wobei in der indexierten Position unterhalb der vordefinierten Öffnungen 5 der Trägerplatte 3 sich die in der Wickelplatte 9 ausgebildeten, korrespondierende Ausnehmungen 14, vorgesehen sind. Entlang der jeweiligen Ausnehmung 14 wird dabei eine Verbindungsbahn VB mit einem entsprechenden Verbindungsanfang VA und einem Verbindungsende VE ausgebildet. Ferner werden die schlauchförmigen Elemente 2 maschinell mittels des zumindest einen fadenförmigen Verbindungselementes 4, 4' über die vordefinierten Öffnungen 5 mit der Trägerplatte 3 verbunden. Dies kann mittels der Verbindungsvorrichtung 8 erfolgen.

Mehr im Detail kann das jeweilige schlauchförmige Element 2 mit der Trägerplatte 3 mittels der Verbindungsvorrichtung 8 entlang der jeweiligen Verbindungsbahn VB der korrespondierenden Ausnehmung 14 über die entsprechend vordefinierte Öffnung 5 der Trägerplatte 3 zumindest einmal, vorteilhaft mehrfach, verbunden werden. Das jeweilige schlauchförmige Element 2 kann je vordefinierter Öffnung 5 also einmal, also einfach, oder mehrfach mit der Trägerplatte 3 verbunden werden.

Insbesondere kann die Wickelplatte 9 hierfür mittels des Verschiebeschlittens 10 zwischen benachbarten vordefinierten Öffnungen 5 der auf der Wickelplatte 9 angeordneten Trägerplatte 3 entlang der korrespondierenden Ausnehmung 14 getaktet bewegt werden und zwar vorzugsweise derart, dass die Nadel 12 der Verbindungseinrichtung 8 mit ihrer jeweiligen Längserstreckung lotrecht oberhalb der vordefinierten, aktuell zu verbindenden Öffnung 5 der Trägerplatte 3 in der jeweiligen Stillstandsphase eines Taktschrittes angeordnet wird, wobei während der Stillstandsphase das jeweilige in einer Schlauchhaltebahn 13 der Wickelplatte 9 aufgenommene schlauchförmige Element 2 maschinell mittels des zumindest einen fadenförmigen Verbindungselementes 4, 4' über diese vordefinierte Öffnung 5 mit der Trägerplatte 3 verbunden wird.

Die Nadel 12 kann dabei in Richtung der Trägerplatte 3 und/oder Wickelplatte 9 und in eine dazu um 180° entgegensetzte Richtung mittels der Verbindungseinrichtung 8 bewegt werden. Vorzugsweise ist dabei die Nadel 12 der Verbindungsvorrichtung 8 in ihrer Längserstreckung lotrecht zu der Bearbeitungsebene E und/oder der Bearbeitungsfläche BF orientiert und kann bis unter die Bearbeitungsebene E mittels der Verbindungsvorrichtung 8 bewegt werden.

Alternativ kann auch vorgesehen sein, dass die Wickelplatte 9 mittels des Verschiebeschlittens 10 zwischen benachbarten vordefinierten Öffnungen 5 der auf der Wickelplatte 9 angeordneten Trägerplatte 3 kontinuierlich entlang der korrespondierenden Ausnehmung 14 bewegt wird und zwar vorzugsweise derart, dass die Nadel 12 der Verbindungseinrichtung 8 mit ihrer Längserstreckung jeweils zumindest während des Zeitraums des maschinellen Verbindens des jeweiligen in der Schlauchhaltebahn 13 der Wickelplatte 9 aufgenommenen schlauchförmigen Elements 2 mittels des zumindest einen fadenförmigen Verbindungselementes 4, 4' oberhalb oder im Wesentlichen oberhalb der jeweiligen vordefinierten Öffnung 5 der Trägerplatte 3 steht, über die das schlauchförmige Element 2 mit der Trägerplatte 3 verbunden wird.

Auch kann das über die Nadel 12 der Verbindungsvorrichtung 8 in die jeweilige Öffnung 5 bis zu einer unterhalb angeordneten Ausnehmung 14 geführte fadenförmige Verbindungselement 4 über die in der entsprechenden Ausnehmung 14 vorgesehene Rückhaltevorrichtung 15 zumindest am Verbindungsanfang VA der entsprechenden Verbindungsbahn VB zurückgehalten werden. Dies verhindert, dass am Verbindungsanfang VA der Verbindungsbahn VB das fadenförmige Verbindungselement 2 während der Aufwärtsbewegung wieder aus der Nadel 12 der Verbindungsvorrichtung 8 gezogen wird.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrundeliegende Erfindungsgedanke verlassen wird.

### Bezugszeichenliste

- 1: System
- 2: schlauchförmiges Element
- 3: Trägerplatte
- 3.1: Trägerplattenoberseite
- 3.2: Trägerplattenunterseite
- 4, 4': fadenförmiges Verbindungselement
- 5: Öffnung
- 6: Bearbeitungstisch
- 6.1: Tischgestell
- 6.2: Öffnung
- 7: Verschiebeeinrichtung
- 8: Verbindungseinrichtung

- 9: Wickelplatte
- 9.1: Plattenoberseite
- 9.2: Plattenunterseite
- 9.3: Indexiereinrichtung
- 9.4: Randabschnitt
- 10: Verschiebeschlitten
- 11: Koppeleinrichtung
- 12: Nadel
- 13: Schlauchbahnen
- 14: Ausnehmungen
- 15: Rückhaltevorrichtung
- 16: Nadelstange
- 17: Greifervorrichtung
- 18.1: Oberfadenspule
- 18.2: Unterfadenspule

- BE: Bearbeitungsebene
- BF: Bearbeitungsfläche
- E: Bearbeitungsebene
- OS: Oberseite
- US: Unterseite
- VB: Verbindungsbahn
- VA: Verbindungsanfang
- VE: Verbindungsende

## Patentansprüche

1. Verfahren zum lagefixierten Verbinden zumindest eines schlauchförmigen Elementes (2) auf einer Trägerplatte (3) mittels zumindest eines fadenförmigen Verbindungselementes (4, 4') über vordefinierte Öffnungen (5) der Trägerplatte (3),
- bei dem das zumindest eine schlauchförmige Element (2) in vordefinierten Schlauchhaltebahnen (13) einer als Montagehilfe ausgebildeten Wickelplatte (9) angeordnet wird,
- bei dem auf die in den Schlauchhaltebahnen (13) befindlichen schlauchförmigen Elemente (2) der Wickelplatte (9) eine Trägerplatte (3) mit vordefinierten Öffnungen (5) aufgelegt und durch die Wickelplatte (9) in einer indexierten Position relativ zu der Wickelplatte (9) gehalten wird, wobei in der indexierten Position unterhalb der vordefinierten Öffnungen (5) der Trägerplatte (3) in der Wickelplatte (9) korrespondierende Ausnehmungen (14) vorgesehen sind,
- bei dem die schlauchförmigen Elemente (2) maschinell mittels des zumindest einen fadenförmigen Verbindungselementes (4, 4') über die vordefinierten Öffnungen (5) mit der Trägerplatte (3) verbunden werden.

2. Verfahren nach Anspruch 1, **dadurch gekennzeichnet, dass** die Wickelplatte (9) mittels einer Verschiebeeinrichtung (7) motorisch gesteuert und/oder geregelt in zumindest zwei um vorzugsweise 90° zueinander verlaufenden Verschieberichtungen (X, Y) auf einem Bearbeitungstisch (6) verschoben wird.

3. Verfahren nach Anspruch 1 oder 2, **dadurch gekennzeichnet, dass** die Verschiebeeinrichtung (7) einen Verschiebeschlitten (10) aufweist, der über zumindest eine Koppeleinrichtung (11) mit der Wickelplatte (9) lösbar verbunden wird.

4. Verfahren nach einem der vorangehenden Ansprüche, **dadurch gekennzeichnet, dass** der Verschiebeschlitten (10) getaktet oder kontinuierlich in den beiden Verschieberichtungen (X, Y) jeweils beidseitig motorisch gesteuert und/oder geregelt angetrieben verschoben wird.

5. Verfahren nach einem der vorangehenden Ansprüche, **dadurch gekennzeichnet, dass** der Verschiebschlitten (10) ein Bewegungsprofil vollzieht, bei dem der Verschiebeschlitten (10) periodisch auf eine Verschiebegeschwindigkeit beschleunigt und anschließend wieder abgebremst wird.

6. Verfahren nach einem der vorangehenden Ansprüche, **dadurch gekennzeichnet, dass** das zumindest eine schlauchförmige Element (2) in an einer Plattenoberseite (9.1) der Wickelplatte (9) als nutförmige Vertiefung ausgebildete Schlauchhaltebahnen (13) eingebracht wird, die mäanderförmig zumindest über einen Teilbereich der Plattenoberseite (9.1) verlaufen.

7. Verfahren nach einem der vorangehenden Ansprüche, **dadurch gekennzeichnet, dass** das schlauchförmige Element (2) zumindest mit einem Teilabschnitt seines Außendurchmessers form- und/oder kontaktschlüssig in der jeweiligen Schlauchhaltebahn (13) gehalten wird.

8. Verfahren nach einem der vorangehenden Ansprüche, **dadurch gekennzeichnet, dass** die Trägerplatte (3) über einen gegenüber der Plattenoberseite (9.1) hochspringenden Randabschnitt (9.4) verschiebesicher auf der Wickelplatte (9) in der indexierten Position gehalten wird.

9. Verfahren nach einem der vorangehenden Ansprüche, **dadurch gekennzeichnet, dass** eine eindeutige Soll-Lage der Trägerplatte (3) relativ auf der Wickelplatte (9) über zumindest eine Indexierungseinrichtung (9.3) festgelegt wird.

10. Verfahren nach einem der vorangehenden Ansprüche, **dadurch gekennzeichnet, dass** über die Längserstreckung der jeweiligen Ausnehmung (14) eine Verbindungsbahn (VB) mit einem Verbindungsanfang (VA) und einem Verbindungsende (VE) ausgebildet wird, entlang der die jeweiligen schlauchförmigen Elemente (2) maschinell mittels des zumindest einen fadenförmigen Verbindungselementes (4, 4') über die vordefinierten Öffnungen (5) mit der Trägerplatte (3) verbunden werden.

11. Verfahren nach einem der vorangehenden Ansprüche, **dadurch gekennzeichnet, dass** als schlauchförmiges Element (2) ein elastisch verformbarer Kühlmittelschlauch verwendet wird.

12. Verfahren nach einem der vorangehenden Ansprüche, **dadurch gekennzeichnet, dass** die schlauchförmigen Elemente (2) mittels einer als Nähmaschine, insbesondere einer als Doppelsteppstichmaschine, ausgebildeten Verbindungsvorrichtung (8) mit der Trägerplatte (3) verbunden werden, die eine oszillierend auf und ab bewegbare Nadelstange (16) mit einer daran angeordneten Nadel (12) aufweist, wobei die Nadel (12) zur Aufnahme eines als Oberfaden ausgebildeten ersten fadenförmigen Verbindungselementes (4) von einer Oberfadenspule (18.1) vorgesehen wird, wobei die Verbindungsvorrichtung (8) zudem eine Greifervorrichtung (17) aufweist, deren rotative Bewegung mit der oszillierenden Bewegung der Nadelstange (16) synchronisiert wird, wobei ein als Unterfaden ausgebildetes zweites fadenförmiges Verbindungselementes (4') auf einer Unterfadenspule (18.2) aufgenommen wird und wobei die Greifervorrichtung (17) mit der Unterfadenspule (18.2) in Nadelstichrichtung unterhalb der Nadel (12) angeordnet wird.

13. Verfahren nach einem der vorangehenden Ansprüche, **dadurch gekennzeichnet, dass** mittels wenigstens einer in zumindest einer Ausnehmung (14) vorgesehenen Rückhaltevorrichtung (15) eine Rückhaltekraft auf das durch die Nadel (12) in die Rückhaltevorrichtung (15) eingestochene erste Verbindungselement (4) ausgeübt wird, die größer ist, als die Abzugskraft für das erste fadenförmige Verbindungselement (4) von der Oberfadenspule (18.1).

14. Verfahren nach einem der vorangehenden Ansprüche, **dadurch gekennzeichnet, dass** als fadenförmiges Verbindungselement (4, 4') ein geflochtener Endloszwirn verwendet wird, der insbesondere aus 100% Polyester hergestellt ist und/oder eine Festigkeit von in etwa 21.000 bis ca. 55.000 cN und/oder eine Bruchdehnung von in etwa 11% bis ca. 28% und/oder einen Thermoschrumpf bei 160° C über 30 min von kleiner als 7,5% aufweist.

15. Verfahren nach einem der vorangehenden Ansprüche, **dadurch gekennzeichnet, dass** das jeweilige schlauchförmige Element (2) mit der Trägerplatte (3) mittels der Verbindungsvorrichtung (8) entlang der jeweiligen Verbindungsbahn (VB) der korrespondierenden Ausnehmung (14) über die entsprechend vordefinierte Öffnung (5) der Trägerplatte (3) zumindest einmal, vorteilhaft mehrfach, verbunden wird.

16. Verfahren nach einem der vorangehenden Ansprüche, **dadurch gekennzeichnet, dass** die Wickelplatte (9) mittels des Verschiebeschlittens (10) zwischen benachbarten vordefinierten Öffnungen (5) der auf der Wickelplatte (9) angeordneten Trägerplatte (3) entlang der korrespondierenden Ausnehmung (14) getaktet bewegt wird und zwar vorzugsweise derart, dass die Nadel (12) der Verbindungseinrichtung (8) mit ihrer jeweiligen Längserstreckung lotrecht oberhalb der vordefinierten, aktuell zu verbindenden Öffnung (5) der Trägerplatte (3) in der jeweiligen Stillstandsphase eines Taktschrittes angeordnet wird, wobei während der Stillstandsphase das jeweilige in einer Schlauchhaltebahn (13) der Wickelplatte (9) aufgenommene schlauchförmige Element (2) maschinell mittels des zumindest einen fadenförmigen Verbindungselementes (4, 4') über diese vordefinierte Öffnung (5) mit der Trägerplatte 3 verbunden wird.

17. Verfahren nach einem der vorangehenden Ansprüche, **dadurch gekennzeichnet, dass** die Wickelplatte (9) mittels des Verschiebeschlittens (10) zwischen benachbarten vordefinierten Öffnungen (5) der auf der Wickelplatte (9) angeordneten Trägerplatte (3) kontinuierlich entlang der korrespondierenden Ausnehmung (14) bewegt wird und zwar vorzugsweise derart, dass die Nadel (12) der Verbindungseinrichtung (8) mit ihrer Längserstreckung jeweils zumindest während des Zeitraums des maschinellen Verbindens des jeweiligen in der Schlauchhaltebahn (13) der Wickelplatte (9) aufgenommenen schlauchförmigen Elements (2) mittels des zumindest einen fadenförmigen Verbindungselementes (4, 4') oberhalb oder im Wesentlichen oberhalb der jeweiligen vordefinierten Öffnung (5) der Trägerplatte (3) steht, über die das schlauchförmige Element (2) mit der Trägerplatte (3) verbunden wird.

18. System zum lagefixierten Verbinden zumindest eines schlauchförmigen Elementes (2), welches in vordefinierten Schlauchhaltebahnen (13) einer als Montagehilfe ausgebildeten Wickelplatte (9) des Systems anordenbar ist, auf einer Trägerplatte (3) mittels zumindest eines fadenförmigen Verbindungselementes (4, 4') über vordefinierte Öffnungen (5) der Trägerplatte (3), zumindest aufweisend einen Bearbeitungstisch (6) mit einer daran angeordneten Verschiebeeinrichtung (7) sowie einer Verbindungseinrichtung (8) zum maschinellen Verbinden der schlauchförmigen Elemente mittels des zumindest einen fadenförmigen Verbindungselementes (4, 4') über die vordefinierten Öffnungen (5) mit der Trägerplatte (3), wobei das System (1) zur Durchführung des Verfahrens gemäß einem der Ansprüche 1 bis 17 ausgebildet ist.

## Claims

1. Method for a positionally fixed connection of at least one tubular element (2) on a support plate (3) by means of at least one thread-like connecting element (4, 4') via predefined openings (5) of the support plate (3),
- in which the at least one tubular element (2) is arranged in predefined tube holding tracks (13) of a winding plate (9) designed as an assembly aid,
- in which a support plate (3) with predefined openings (5) is placed onto the tubular elements (2) of the winding plate (9) located in the tube holding tracks (13) and is held by the winding plate (9) in an indexed position relative to the winding plate (9), wherein in the indexed position, corresponding recesses (14) are provided in the winding plate (9) below the predefined openings (5) of the support plate (3),
- in which the tubular elements (2) are connected by machine to the support plate (3) by means of the at least one thread-like connecting element (4, 4') via the predefined openings (5).

2. Method according to claim 1, **characterized in that** the winding plate (9) is displaced on a processing table (6) by means of a displacement device (7) in a motor-controlled and/or regulated manner in at least two displacement directions (X, Y) preferably extending 90° to one another.

3. Method according to claim 1 or 2, **characterized in that** the displacement device (7) comprises a displacement carriage (10), which is releasably connected to the winding plate (9) via at least one coupling device (11).

4. Method according to one of the preceding claims, **characterized in that** the displacement carriage (10) is displaced in a timed or continuous manner in the two displacement directions (X, Y), respectively in a motor-controlled and/or regulated manner on both sides.

5. Method according to one of the preceding claims, **characterized in that** the displacement carriage (10) executes a movement profile, in which the displacement carriage (10) is periodically accelerated to a displacement speed and then decelerated again.

6. Method according to one of the preceding claims, **characterized in that** the at least one tubular element (2) is inserted into tube holding tracks (13) formed as a groove-shaped recess on a plate upper side (9.1) of the winding plate (9), which tube holding tracks run in a meandering manner at least over a partial region of the plate upper side (9.1).

7. Method according to one of the preceding claims, **characterized in that** the tubular element (2) is held in the respective tube holding track (13) in a form-fitting and/or contact-locking manner at least with a partial section of its outer diameter.

8. Method according to one of the preceding claims, **characterized in that** the support plate (3) is held secured against displacement in the indexed position on the winding plate (9) via an edge section (9.4) that is raised relative to the plate upper side (9.1).

9. Method according to one of the preceding claims, **characterized in that** an unambiguous target position of the support plate (3) relative to the winding plate (9) is determined via at least one indexing device (9.3).

10. Method according to one of the preceding claims, **characterized in that** a connecting track (VB) with a connecting start (VA) and a connecting end (VE) is formed over the longitudinal extension of the respective recess (14), along which the respective tubular elements (2) are connected by machine to the support plate (3) by means of the at least one thread-like connecting element (4, 4') via the predefined openings (5).

11. Method according to one of the preceding claims, **characterized in that** an elastically deformable coolant tube is used as tubular element (2).

12. Method according to one of the preceding claims, **characterized in that** the tubular elements (2) are connected to the support plate (3) by means of a connecting device (8) formed as a sewing machine, in particular as a lockstitch machine, which comprises a needle bar (16) that can be moved in an oscillating manner up and down with a needle (12) arranged thereon, wherein the needle (12) is provided to receive a first thread-like connecting element (4) formed as an upper thread from an upper thread spool (18.1), wherein the connecting device (8) also has a gripper device (17), the rotary movement of which is synchronized with the oscillating movement of the needle bar (16), wherein a second thread-like connecting element (4') formed as a lower thread is held on a bobbin (18.2) and wherein the gripper device (17) is arranged below the needle (12) in the needle stitch direction along with the bobbin (18.2).

13. Method according to one of the preceding claims, **characterized in that**, by means of at least one retaining device (15) provided in at least one recess (14), a retaining force is exerted on the first connecting element (4) pierced into the retaining device (15) by the needle (12), which force is greater than the pull-off force for the first thread-like connecting element (4) from the upper thread spool (18.1).

14. Method according to one of the preceding claims, **characterized in that** a continuous braided twine is used as the thread-like connecting element (4, 4'), which is made in particular from 100% polyester and/or comprises a strength of around 21,000 to 55,000 cN and/or an elongation at break of around 11% to approx. 28% and/or heat shrinkage of less than 7.5% at 160°C over 30 minutes.

15. Method according to one of the preceding claims, **characterized in that** the respective tubular element (2) is connected at least once, advantageously several times, to the support plate (3) by means of the connecting device (8) along the respective connecting track (VB) of the corresponding recess (14) via the correspondingly predefined opening (5) of the support plate (3).

16. Method according to one of the preceding claims, **characterized in that** the winding plate (9) is moved in a timed manner along the corresponding recess (14) by means of the displacement carriage (10) between adjacent predefined openings (5) of the support plate (3) arranged on the winding plate (9) and preferably in such a way that the needle (12) of the connecting device (8) is arranged with its respective longitudinal extension vertically above the predefined opening (5) of the support plate (3) to be currently connected in the respective standstill phase of a cycle step, wherein during the standstill phase, the respective tubular element (2) received in a tube holding track (13) of the winding plate (9) is connected by machine to the support plate (3) by means of the at least one thread-like connecting element (4, 4') via said predefined opening (5).

17. Method according to one of the preceding claims, **characterized in that** the winding plate (9) is moved continuously along the corresponding recess (14) by means of the displacement carriage (10) between adjacent predefined openings (5) of the support plate (3) arranged on the winding plate (9) and preferably in such a way that the needle (12) of the connecting device (8) is positioned with its longitudinal extension above or substantially above the respective predefined opening (5) of the support plate (3) via which the tubular element (2) is connected to the support plate (3) respectively at least during the period in which the respective tubular element (2) received in the tube holding track (13) of the winding plate (9) is connected by machine by means of the at least one thread-like connecting element (4, 4').

18. System for the positionally fixed connection of at least one tubular element (2), which can be arranged in predefined tube holding tracks (13) of a winding plate (9) of the system designed as an assembly aid, on a support plate (3) by means of at least one thread-like connecting element (4, 4') via predefined openings (5) of the support plate (3), at least comprising a processing table (6) with a displacement device (7) arranged thereon as well as a connecting device (8) for connecting the tubular elements by machine to the support plate (3) by means of the at least one thread-like connecting element (4, 4') via the predefined openings (5), wherein the system (1) is designed to carry out the method according to one of claims 1 to 17.

## Revendications

1. Procédé de raccordement à position fixe d'au moins un élément tubulaire (2) sur une plaque de support (3) au moyen d'au moins un élément de raccordement en forme de fil (4, 4') par le biais d'ouvertures (5) prédéfinies de la plaque de support (3),
- pour lequel au moins l'élément tubulaire (2) est disposé dans des voies de maintien de tuyau (13) prédéfinies d'une plaque d'enroulement (9) constituée comme une assistance au montage,
- pour lequel une plaque de support (3) avec des ouvertures (5) prédéfinies est placée sur les éléments tubulaires (2) de la plaque d'enroulement (9), se trouvant dans les voies de maintien de tuyau (13) et est maintenue par la plaque d'enroulement (9) dans une position indexée par rapport à la plaque d'enroulement (9), sachant que dans la position indexée des évidements (14) correspondants sont prévus dans la plaque d'enroulement (9) en dessous des ouvertures prédéfinies (5) de la plaque de support (3),
- pour lequel les éléments tubulaires (2) sont reliés mécaniquement à la plaque de support (3) au moyen d'au moins un élément de raccordement en forme de fil (4, 4') par des ouvertures prédéfinies (5).

2. Procédé selon la revendication 1, **caractérisé en ce que** la plaque d'enroulement (9) commandée et/ou réglée de façon motorisée au moyen d'un dispositif de déplacement (7) est déplacée sur une table de traitement (6) dans au moins deux directions de déplacement (X, Y) passant de préférence à 90° l'une par rapport à l'autre.

3. Procédé selon la revendication 1 ou 2, **caractérisé en ce que** le dispositif de déplacement (7) comporte un chariot de déplacement (10), qui est relié de façon amovible par au moins un dispositif d'accouplement (11) à la plaque d'enroulement (9).

4. Procédé selon l'une quelconque des revendications précédentes, **caractérisé en ce que** le chariot de déplacement (10) est déplacé en cadence ou en continu dans les deux directions de déplacement (X, Y) respectivement entraîné des deux côtés commandé et/ou régulé de façon motorisée.

5. Procédé selon l'une quelconque des revendications précédentes, **caractérisé en ce que** le chariot de déplacement (10) réalise un profil de mouvement pour lequel le chariot de déplacement (10) est périodiquement accéléré à une vitesse de déplacement et est ensuite à nouveau freiné.

6. Procédé selon l'une quelconque des revendications précédentes, **caractérisé en ce que** l'au moins un élément tubulaire (2) est introduit dans des voies de maintien de tuyau (13) constituées sur une face supérieure de plaque (9.1) de la plaque d'enroulement (9) sous la forme d'une cavité en forme de rainure, qui passent en forme de méandres au moins par une partie de zone de la face supérieure de plaque (9.1).

7. Procédé selon l'une quelconque des revendications précédentes, **caractérisé en ce que** l'élément tubulaire (2) est maintenu au moins avec une partie de section de son diamètre extérieur par conformité de forme et/ou de contact dans la voie de maintien de tuyau (13) respective.

8. Procédé selon l'une quelconque des revendications précédentes, **caractérisé en ce que** la plaque de support (3) est maintenue sécurisée en déplacement sur la plaque d'enroulement (9) dans la position indexée par le biais d'une section de bord (9.4) passant en hauteur par rapport à la face supérieure de plaque (9.1).

9. Procédé l'une quelconque des revendications précédentes, **caractérisé en ce qu'**une position théorique précise de la plaque de support (3) est définie par rapport à la plaque d'enroulement (9) par au moins un dispositif d'indexage (9.3).

10. Procédé selon l'une quelconque des revendications précédentes, **caractérisé en ce qu'** une voie de raccordement (VB) avec un début de raccordement (VA) et à une extrémité de raccordement (VE) est constituée sur l'extension longitudinale de l'évidement (14) respectif, le long de laquelle les éléments tubulaires (2) respectifs sont reliés de façon mécanisée à la plaque de support (3) au moyen d'au moins un élément de raccordement en forme de fil (4, 4') par les ouvertures (5) prédéfinies.

11. Procédé selon l'une quelconque des revendications précédentes, **caractérisé en ce qu'**un tuyau de frigorigène élastiquement déformable est utilisé en tant qu'élément tubulaire (2).

12. Procédé selon l'une quelconque des revendications précédentes, **caractérisé en ce que** les éléments tubulaires (2) sont reliés à la plaque de support (3) au moyen d'un dispositif de raccordement (8) constitué sous la forme d'une machine à coudre, en particulier d'une machine à point noué double, qui comporte une barre à aiguille (16) mobile oscillant de haut en bas avec une aiguille (12) disposée dessus, sachant que l'aiguille (12) est prévue pour loger un premier élément de raccordement (4) en forme de fil constitué en tant que fil supérieur d'une bobine de fil supérieur (18.1), sachant que le dispositif de raccordement (8) comporte en outre un dispositif de préhension (17), dont le mouvement rotatif est synchronisé avec le mouvement oscillant de la barre d'aiguille (16), sachant qu'un deuxième élément de raccordement en forme de fil (4') constitué en tant que fil inférieur est logé sur une bobine de fil inférieur (18.2) et sachant que le dispositif de préhension (17) avec la bobine de fil inférieur (18.2) est disposé dans la direction de piqûre d'aiguille en dessous de l'aiguille (12).

13. Procédé selon l'une quelconque des revendications précédentes, **caractérisé en ce qu'**une force de retenue est exercée sur le premier élément de raccordement (4) piqué par l'aiguille (12) dans le dispositif de retenue (15) au moyen d'au moins un dispositif de retenue (15) prévu dans au moins un évidement (14), qui est plus grande que la force de retrait pour le premier élément de raccordement (4) en forme de fil de la bobine de fil supérieur (18.1).

14. Procédé selon l'une quelconque des revendications précédentes, **caractérisé en ce qu'**un fil retors sans fin tressé est utilisé en tant qu'élément de raccordement en forme de fil (4, 4'), qui est fabriqué en particulier à 100 % en polyester et/ou comporte une résistance d'environ 21 000 à environ 55 000 cN et/ou un allongement à la rupture d'environ 11 % à environ 28 % et/ou un retrait thermique à 160 °C sur 30 minutes inférieur à 7,5 %.

15. Procédé selon l'une quelconque des revendications précédentes, **caractérisé en ce que** l'élément tubulaire (2) respectif est relié au moins une fois, de façon avantageuse plusieurs fois, à la plaque de support (3) au moyen du dispositif de raccordement (8) le long de la voie de raccordement (VB) respective de l'évidement (14) correspondant par l'ouverture (5) conformément prédéfinie de la plaque de support (3).

16. Procédé selon l'une quelconque des revendications précédentes, **caractérisé en ce que** la plaque d'enroulement (9) est déplacée en cadence le long de l'évidement (14) correspondant au moyen du chariot de déplacement (10) entre les ouvertures (5) prédéfinies voisines de la plaque de support (3) disposée sur la plaque d'enroulement (9) et effectivement de préférence de telle manière que l'aiguille (12) du dispositif de raccordement (8) est disposée avec son extension longitudinale respective verticalement au-dessus de l'ouverture (5) prédéfinie, réellement à raccorder de la plaque de support (3) dans la phase d'arrêt respective d'un pas de cadence, sachant que pendant la phase d'arrêt, l'élément tubulaire (2) respectif logé dans une voie de maintien de tuyau (13) de la plaque d'enroulement (9) est relié mécaniquement au moyen d'au moins un élément de raccordement en forme de fil (4, 4') à la plaque de support (3) par cette ouverture (5) prédéfinie.

17. Procédé selon l'une quelconque des revendications précédentes, **caractérisé en ce que** la plaque d'enroulement (9) est déplacée en continu le long de l'évidement (14) correspondant au moyen du chariot de déplacement (10) entre les ouvertures (5) voisines de la plaque de support (3) disposée sur la plaque d'enroulement (9) et effectivement de préférence de telle manière que l'aiguille (12) du dispositif de raccordement (8) avec son extension longitudinale respectivement au moins pendant la période du raccordement mécanique de l'élément tubulaire (2) respectif logé dans la voie de maintien de tuyau (13) de la plaque d'enroulement (9) au moyen d'au moins un élément de raccordement en forme de fil (4, 4') se trouve au-dessus ou pour l'essentiel au-dessus de l'ouverture (5) prédéfinie respective de la plaque de support (3) par laquelle l'élément tubulaire (2) est relié à la plaque de support (3).

18. Système de raccordement à position fixe d'au moins un élément tubulaire (2), lequel peut être disposé dans des voies de maintien de tuyau (13) prédéfinies d'une plaque d'enroulement (9) constituée en tant qu'assistance au montage du système sur une plaque de support (3) au moyen d'au moins un élément de raccordement (4, 4') en forme de fil sur des ouvertures (5) prédéfinies de la plaque de support (3), comportant au moins une table de traitement (6) avec un dispositif de déplacement (7) disposé dessus ainsi qu'un dispositif de raccordement (8) pour le raccordement mécanisé des éléments tubulaires à la plaque de support (3) au moyen d'au moins un élément de raccordement en forme de fil (4, 4') par les ouvertures (5) prédéfinies, sachant que le système (1) est constitué pour exécuter le procédé selon l'une quelconque des revendications 1 à 17.
